# EUROPÄISCHE PATENTSCHRIFT

(11) **EP 2 990 808 B1**
(45) Veröffentlichungstag und Bekanntmachung des Hinweises auf die Patenterteilung: **14.11.2018**
(21) Anmeldenummer: 15171602.4
(22) Anmeldetag: 11.06.2015
(51) Int. Cl.: G01R 1/04, G01R 15/18, H01F 27/30

(54) **HALTERUNGSEINRICHTUNG FÜR EINE ROGOWSKISPULE**
FIXING DEVICE FOR A ROGOWSKI COIL
DISPOSITIF DE FIXATION D'UN ENROULEMENT DE ROGOWSKI

(30) Priorität: 25.08.2014 DE 102014112105
(43) Veröffentlichungstag der Anmeldung: 02.03.2016
(73) Patentinhaber: PHOENIX CONTACT GmbH & Co. KG, 32825 Blomberg (DE)
(72) Erfinder: BECKER, Markus, 33102 Paderborn (DE); SENGER, Andreas, 33184 Altenbeken (DE); LOCKSTEDT, Kay, 32825 Blomberg (DE); GOCKEL, Rainer, 31812 Bad Pyrmont (DE)
(74) Vertreter: Bringemeier, Ulrich Heinz

(56) Entgegenhaltungen:
- DE-A1- 19 811 366
- DE-B3-102012 109 869
- US-A1- 2011 012 587
- PhoenixContactDE: "Schnell installieren auf engstem Raum: PACT RCP Stromwandler zum Nachrüsten - PHOENIX CONTACT", , 8. Juli 2014 (2014-07-08), Seite 1 pp., XP054976417, Gefunden im Internet: URL:https://www.youtube.com/watch?v=I3i6GA nNn3k [gefunden am 2016-03-10]
- Anonymous: "Strommesstechnik einfach nachrüsten", , 12. Mai 2014 (2014-05-12), Seite 1, XP55256999, Gefunden im Internet: URL:http://www.innovations-report.de/html/ berichte/energie-elektrotechnik/strommesst echnik-einfach-nachruesten.html [gefunden am 2016-03-10]
- "Energy and current measuring technology Converting, measuring, and monitoring", , 1. April 2014 (2014-04-01), XP055256918, Gefunden im Internet: URL:http://www.igrowth-tech.com/?datasheet /菲尼克斯?位 電?型?(上).pdf [gefunden am 2016-03-09]

## Beschreibung

Die Erfindung betrifft eine Halterungseinrichtung zum Befestigen einer Rogowskispule an einer Stromleitungseinrichtung nach dem Oberbegriff des Anspruchs 1.

Eine derartige Halterungseinrichtung umfasst eine Rogowskispule, die einen zu einer Spule gewickelten Leitungsabschnitt aufweist und mit einem Gehäuseteil der Halterungseinrichtung verbunden ist.

Unter einer Rogowskispule versteht man eine toroidförmige Spule, die (in der Regel) keinen ferromagnetischen Kern aufweist. Eine Rogowskispule weist einen Leiterdraht auf, der um einen Körper (aus einem nicht-ferromagnetischen Material) gewickelt ist, wobei beide Anschlüsse der Spule an einem Ende des Körpers angeordnet sind und dafür ein Anschluss in magnetisch neutraler Weise entlang des Körpers zum anderen Anschluss zurückgeführt wird. Eine Rogowskispule dient zur Messung von Wechselstrom und wird dazu um eine stromführende Stromleitungseinrichtung, beispielsweise eine Kabelader oder eine Stromschiene z.B. in einem Schaltschrank, herumgelegt.

Solche Rogowskispulen kommen beispielsweise auch an Stromschienen zum Einsatz, die im Betrieb große Ströme führen und sich auf vergleichsweise große Temperaturen, beispielsweise jenseits 100°C, erhitzen können. Berührt eine Rogowskispule die Stromschiene, so kann es aufgrund der heißen Temperaturen an der Stromschiene gegebenenfalls zu einer Beschädigung an der Rogowskispule, insbesondere einer Kunststoffummantelung der Rogowskispule, kommen, wenn diese nicht für solch heiße Temperaturen ausgelegt ist.

Zudem kann es, wenn eine Rogowskispule um eine Stromschiene gelegt wird, gegebenenfalls zu einem Verrutschen oder einer sonstigen Lageänderung der Rogowskispule relativ zu der Stromschiene kommen, was über die Rogowskispule erhaltene Messergebnisse beeinflussen kann.

Aus der DE 198 11 366 A1 ist ein Stromsensor bekannt, der eine Rogowskispule aufweist, die um einen Leiter herumgelegt werden kann. Der Stromsensor kann mit einem Sensorgehäuse an mehreren Leitern angeordnet werden.

Aus der DE 10 2010 012 834 A1 ist eine Rogowskispule bekannt, die um einen Leiter herumzulegen ist. Die Rogowskispule ist Bestandteil einer Messanordnung und mit einer Integratorschaltung zum Erzeugen eines Spannungssignals, das zum über die Rogowskispule erfassten Wechselstrom proportional ist, verbunden.

Eine Halterungseinrichtung gemäß Oberbegriff von Anspruch 1 ist aus folgenden Dokumenten bekannt:
"Schnell installieren auf engstem Raum: PACT RCP Stromwandler zum Nachrüsten-Phoenix Contact" (Fundstelle: URL: https://www.youtube.com/watch?v=I3i6GAnNn3k),
"Strommesstechnik einfach nachrüsten" (Fundstelle: URL: http://www.innovations-report.de/html/berichte/energie-elektrotechnik/strommesstechnik-einfach-nachruesten.html),
"Energy and current measuring technology Converting, measuring, and monitoring" (Fundstelle: URL:http://www.igrowth-tech.com/?datasheet
   /菲尼克斯?位
   電?型?(&#x4EOA;).pdf).

Aufgabe der vorliegenden Erfindung ist es, eine Halterungseinrichtung für eine Rogowskispule bereitzustellen, die einen definierten Halt und eine definierte Lage der Rogowskispule an einer Stromeinrichtung schafft und eine berührungsfreie Befestigung der Rogowskispule an der Stromleitungseinrichtung ermöglicht, wobei die Lage der Rogowskispule relativ zur Stromleitungseinrichtung veränderbar sein soll.

Diese Aufgabe wird durch einen Gegenstand mit den Merkmalen des Anspruchs 1 gelöst. Demnach weist die Halterungseinrichtung ein Befestigungsteil auf, das an eine zum Leiten eines Stroms ausgebildete Stromleitungseinrichtung ansetzbar und lösbar mit dem Gehäuseteil verbindbar ist.

Dies geht von dem Gedanken aus, die Halterungseinrichtung funktional zweizuteilen. So weist die Halterungseinrichtung einerseits ein Gehäuseteil auf, mit dem die Rogowskispule verbunden ist. Andererseits weist die Halterungseinrichtung ein Befestigungsteil auf, das an die Stromleitungseinrichtung ansetzbar ist und somit zum Befestigen der Halterungseinrichtung an der Stromleitungseinrichtung dient. Dadurch, dass das Gehäuseteil lösbar mit dem Befestigungsteil verbindbar ist, kann das Befestigungsteil zunächst ohne das Gehäuseteil, also ohne die mit dem Gehäuseteil verbundene Rogowskispule, an der Stromleitungseinrichtung befestigt werden, um sodann das Gehäuseteil mit der daran angeordneten Rogowskispule an das Befestigungsteil anzusetzen. Weil das Gehäuseteil von dem Befestigungsteil lösbar ist, kann die Rogowskispule bei Bedarf wieder von der Stromleitungseinrichtung entnommen werden, indem das Gehäuseteil von dem Befestigungsteil gelöst wird.

Das Gehäuseteil kann zum Verbinden mit dem Befestigungsteil beispielsweise in eine Ansetzrichtung an das Befestigungsteil angesetzt werden. In verbundenem Zustand ist das Gehäuseteil dann insbesondere formschlüssig mit dem Befestigungsteil verbunden.

Erfindungsgemäß ist das Gehäuseteil in verbundenem Zustand entlang einer Drehrichtung, gerichtet beispielsweise um die Ansetzrichtung, zu dem Befestigungsteil verdrehbar. Dies ermöglicht, die Lage des Gehäuseteils mit der daran angeordneten Rogowskispule relativ zu dem Befestigungsteil anzupassen, so dass die Rogowskispule beispielsweise so an einer Stromleitungseinrichtung angebracht werden kann, dass sie die Stromleitungseinrichtung, beispielsweise eine Stromschiene, nicht berührt. Durch Verdrehen des Gehäuseteils relativ zu dem Befestigungsteil wird die Lage der Rogowskispule relativ zu der Stromleitungseinrichtung verändert, wobei die Rogowskispule vorteilhafterweise in einer Ebene verlegt ist, in der sich die Drehachse, um die das Gehäuseteil relativ zu dem Befestigungsteil verdrehbar ist, erstreckt.

Zum Verbinden des Gehäuseteils mit dem Befestigungsteil weist das Gehäuseteil oder das Befestigungsteil mindestens ein Rastelement auf, das durch Ansetzen des Gehäuseteils an das Befestigungsteil rastend mit einem zugeordneten Formschlusselement des jeweils anderen Teils, also des Befestigungsteils oder des Gehäuseteils, in Eingriff gebracht werden kann. Durch Ansetzen des Gehäuseteils an das Befestigungsteil wird ein Formschluss zwischen dem mindestens einen Rastelement und dem Formschlusselement hergestellt, so dass in verbundenem Zustand das Gehäuseteil formschlüssig an dem Befestigungsteil festgelegt ist. Bei Ansetzen des Gehäuseteils an das Befestigungsteil schnappt das Rastelement mit dem Formschlusselement in Eingriff, so dass in verbundenem Zustand das Gehäuseteil entgegen der Ansetzrichtung axial an dem Befestigungsteil festgelegt ist, dabei aber relativ zu dem Befestigungsteil verdrehbar ist.

Das Gehäuseteil kann in einer konkreten Ausgestaltung ein Ansetzelement aufweisen, mit dem das Gehäuseteil an das Befestigungsteil angesetzt werden kann. Das Ansetzelement kann beispielsweise zylindrisch ausgebildet sein und von einem Gehäusekörper des Gehäuseteils in Richtung der Ansetzrichtung vorstehen.

An seinem vom Gehäusekörper abgewandten Ende weist das Ansetzelement beispielsweise eine Öffnung auf, in die das Befestigungsteil mit mindestens einem Rastelement eingesetzt werden kann und in der ein Formschlusselement zum Eingriff mit dem mindestens einen Rastelement des Befestigungsteils angeordnet ist. Das Ansetzelement kann somit mit seiner Öffnung auf ein oder mehrere Rastelemente am Befestigungsteil aufgesetzt werden, wodurch ein Formschluss zwischen dem Formschlusselement des Ansetzelements und dem einen oder den mehreren Rastelementen des Befestigungsteils hergestellt wird, so dass das Gehäuseteil formschlüssig an dem Befestigungsteil gehalten ist.

Das Ansetzelement kann hierbei derart geformt sein, dass grundsätzlich auch ein Ansetzen des Gehäuseteils an einen Stromleiter ohne Verwendung des Befestigungsteils möglich ist. Insbesondere kann das Ansetzelement an einem vom Gehäusekörper abgewandten Randabschnitt derart konkav geformt sein, dass das Ansetzelement mit dem Randabschnitt an einen runden Stromleiter angesetzt werden kann. Das Gehäuseteil mit der daran angeordneten Rogowskispule kann somit grundsätzlich auch ohne das Befestigungsteil verwendet werden. Die Variabilität der Halterungseinrichtung zum Befestigen der Rogowskispule an einer Stromleitungseinrichtung wird hierdurch noch erhöht.

Um ein Befestigen des Gehäuseteils an einer Stromleitungseinrichtung unabhängig von dem Befestigungsteil zu ermöglichen, können an dem Ansetzelement ein oder mehrere Befestigungsöffnungen vorgesehen sein, durch die eine Befestigungseinrichtung, beispielsweise ein Kabelbinder, hindurchgeführt werden kann. Die Befestigungsöffnungen können so an dem Ansetzelement angebracht sein, dass eine Befestigungseinrichtung, beispielsweise ein Kabelbinder, in günstiger Weise um einen Stromleiter herum gelegt werden kann.

Um die Lage der Rogowskispule bei an eine Stromleitungseinrichtung angesetztem Befestigungsteil relativ zu der Stromleitungseinrichtung in gewünschter Weise einzustellen, ist das Gehäuseteil, wie bereits ausgeführt, in verbundenem Zustand relativ zu dem Befestigungsteil verdrehbar. Dies ermöglicht eine flexible Verstellbarkeit der Rogowskispule relativ zu der Stromleitungseinrichtung bei mit dem Befestigungsteil verbundenem Gehäuseteil und somit bei bereits an der Stromleitungseinrichtung gehaltener Rogowskispule.

Um hierbei sicherzustellen, dass die Rogowskispule nach Verdrehen des Gehäuseteils relativ zu dem Befestigungsteil ihre eingestellte Lage beibehält, ist eine Schwergängigkeit in der drehbaren Verbindung zwischen dem Gehäuseteil und dem Befestigungsteil vorgesehen, die bewirkt, dass nach einem Verdrehen des Gehäuseteils relativ zu dem Befestigungsteil durch einen Nutzer das Gehäuseteil seine Drehstellung beibehält und sich beispielsweise nicht wieder zurückdreht. Hierzu ist an dem Gehäuseteil oder dem Befestigungsteil eine Ratschverzahnung vorgesehen, die in verbundenem Zustand des Gehäuseteils mit einem zugeordneten Ratschelement des jeweils anderen Bauteils, also des Befestigungsteils oder des Gehäuseteils, in Eingriff steht. Der Eingriff ist hierbei derart, dass das Gehäuseteil und das Befestigungsteil in verbundenem Zustand ratschend durch einen Nutzer zueinander verdreht werden können, indem das Ratschelement über die Ratschverzahnung bewegt wird.

Eine Ratschverzahnung kann beispielsweise eine Anzahl von periodisch aneinander anschließenden, an ihren Spitzen abgerundeten Zähnen aufweisen, die mit einem Ratschelement, beispielsweise einer anderen Ratschverzahnung, in Eingriff stehen. Die Formgebung der Ratschverzahnung ist hierbei derart, dass bei Aufbringen einer Kraft auf das Gehäuseteil, die einen vorbestimmten Schwellwert überschreitet, das Ratschelement über die Ratschverzahnung hinweg bewegbar ist und somit ein Verstellen des Gehäuseteils relativ zu dem Befestigungsteil möglich ist. Wirkt keine oder nur eine geringe Kraft auf das Gehäuseteil, so wird das Gehäuseteil über den Eingriff der Ratschverzahnung mit dem Ratschelement in seiner eingestellten Drehstellung relativ zu dem Befestigungsteil gehalten, so dass die Lage der Rogowskispule festgelegt ist.

Das Befestigungsteil kann in einer Ausgestaltung ein Halteelement und ein zu dem Halteelement verstellbares Verbindungselement aufweisen. Das Halteelement dient zum Ansetzen des Befestigungsteils an eine Stromleitungseinrichtung und kann hierzu eine geeignete Aufnahmeöffnung, in die die Stromleitungseinrichtung eingesetzt werden kann, aufweisen.

Das Verbindungselement kann beispielsweise ein Klemmelement aufweisen, wobei durch Verstellen des Verbindungselements relativ zu dem Halteelement das Klemmelement relativ zu dem Halteelement verstellt werden kann, um auf diese Weise eine klemmende Verbindung des Halteelements mit einer an das Halteelement angesetzten Stromleitungseinrichtung herzustellen.

Das Klemmelement kann beispielsweise als Stift ausgebildet sein, der in die Aufnahmeöffnung des Haltelements hineinragt. Durch Verstellen des Verbindungselements relativ zu dem Halteelement kann die Lage des Klemmelements in der Aufnahmeöffnung verändert werden, so dass auf diese Weise das Halteelement mit der Stromleitungseinrichtung verklemmt werden kann.

Die Aufnahmeöffnung an dem Halteelement kann beispielsweise U-förmig ausgebildet sein. Hierzu kann das Halteelement beispielsweise einen Körper, eine an dem Körper angeordnete Basis und einen an die Basis anschließenden Schenkel aufweisen. Der Körper und der Schenkel bilden Seitenschenkel einer U-Form, die von der Basis komplettiert wird. Mit der U-förmigen Aufnahmeöffnung kann das Halteelement an einen im Querschnitt beispielsweise rechteckigen Stromleiter, beispielsweise eine Stromschiene, angesetzt werden, wobei über das Klemmelement des Verbindungselements eine klemmende Verbindung zwischen dem Halteelement und der Stromleitungseinrichtung in der Aufnahmeöffnung hergestellt werden kann.

In einer Ausgestaltung ist in die Aufnahmeöffnung ein aus Metall gefertigtes Winkelelement eingesetzt, das eine Anlagefläche zur Anlage des Halteelements mit der Stromleitungseinrichtung bereitstellt. Bei an eine Stromleitungseinrichtung angesetztem Halteelement liegt das Winkelelement an der Stromleitungseinrichtung, beispielsweise einer Stromschiene, an. Dadurch, dass das Element aus Metall hergestellt ist, kann es einen festen Sitz des Halteelements an einer Stromschiene auch bei gegebenenfalls hohen Temperaturen an der Stromschiene gewährleisten.

Die Aufnahmeöffnung kann hierbei beispielsweise so ausgebildet sein, dass bei an eine Stromleitungseinrichtung angesetztem Halteelement nur das Winkelelement an der Stromleitungseinrichtung anliegt, nicht aber andere, aus einem anderen Material, beispielsweise Kunststoff, gefertigte Abschnitte des Halteelements.

Die Rogowskispule ist mit dem Gehäuseteil verbunden. Die Rogowskispule kann hierbei mit einem ersten Ende fest mit dem Gehäuseteil verbunden sein, während das andere, zweite Ende der Rogowskispule lösbar an das Gehäuseteil angeschlossen werden kann. Dadurch, dass ein Ende der Rogowskispule in lösbarer Weise mit dem Gehäuseteil verbunden werden kann, kann die Rogowskispule in vorteilhafter Weise um eine Stromleitungseinrichtung, beispielsweise eine Stromschiene, herumgelegt werden, um sodann das zweite Ende der Rogowskispule mit dem Gehäuseteil zu verbinden und somit die Lage der Rogowskispule in ihrer Erstreckung um die Stromleitungseinrichtung zu fixieren.

Die (lösbare) Verbindung des zweiten Endes der Rogowskispule mit dem Gehäuseteil kann beispielsweise über eine mechanische Verschlussvorrichtung, z.B. einen Bajonettverschluss, erfolgen. Die Verschlussvorrichtung dient zur mechanischen Fixierung des zweiten Endes der Rogowskispule an dem Gehäuseteil, nicht aber zur elektrischen Verbindung.

In dem Gehäuseteil ist, in einer Ausgestaltung der Halterungseinrichtung, eine Auswerteelektronik zum Auswerten von über die Rogowskispule erhaltenen Signalen eingefasst. Die Rogowskispule kann beispielsweise zum hochohmigen Messen einer in der Rogowskispule induzierten Spannung ausgelegt sein. Über die Auswerteelektronik wird eine an der Rogowskispule induzierte Spannung aufgenommen und ausgewertet, um anhand der induzierten Spannung auf einen in der Stromleitungseinrichtung geführten Wechselstrom zu schließen.

Wie gesagt kann die Halterungseinrichtung grundsätzlich auch ohne ein Befestigungsteil verwendet werden, indem das Gehäuseteil an eine Stromleitungseinrichtung angesetzt wird. In diesem Fall umfasst die Halterungseinrichtung eine Rogowskispule, die einen zu einer Spule gewickelten Leitungsabschnitt aufweist, und ein Gehäuseteil, mit dem die Rogowskispule verbunden ist. Das Gehäuseteil weist ein Ansetzelement auf, das an einem Randabschnitt derart konkav geformt ist, dass das Ansetzelement mit seinem Randabschnitt an eine im Leitungsquerschnitt runde Stromleitereinrichtung ansetzbar ist, und mindestens eine Öffnung als Durchgriff für eine Befestigungseinrichtung zum Befestigen des Gehäuseteils an einer im Leitungsquerschnitt runden Stromleitungseinrichtung aufweist.

Durch die konkave Formgebung des Randabschnitts des Ansetzelements kann das Gehäuseteil direkt - ohne Verwendung eines Befestigungsteils - an eine Stromleitungseinrichtung mit rundem Leitungsquerschnitt angesetzt werden. Die konkave Formgebung des Randabschnitts kann auf einen runden Stromleiter mit bestimmtem Durchmesser angepasst sein. Die konkave Formgebung kann aber auch eine Einkerbung oder dergleichen ausbilden, so dass das Gehäuseteil mit dem Randabschnitt des Ansetzelements an Stromleiter unterschiedlichen Durchmessers angesetzt werden kann.

Der der Erfindung zugrunde liegende Gedanke soll nachfolgend der in den Figuren dargestellten Ausführungsbeispiele näher erläutert werden. Es zeigen:
- Fig. 1: eine Ansicht eines Ausführungsbeispiels einer Halterungseinrichtung zum Anbringen einer Rogowskispule an einer Stromleitungseinrichtung in Form einer Stromschiene;
- Fig. 2: eine Seitenansicht der Anordnung gemäß Fig. 1;
- Fig. 3: eine gesonderte, perspektivische Ansicht eines Befestigungsteils der Halterungseinrichtung an einer Stromschiene;
- Fig. 4A: eine perspektivische Ansicht der Halterungseinrichtung, vor dem Ansetzen eines Gehäuseteils an dem Befestigungsteil;
- Fig. 4B: eine Seitenansicht der Anordnung gemäß Fig. 4A;
- Fig. 4C: eine Längsschnittansicht der Anordnung gemäß Fig. 4B;
- Fig. 5: eine Längsschnittansicht der Halterungseinrichtung bei an das Befestigungsteil angesetztem Gehäuseteil;
- Fig. 6A: eine Ansicht des Gehäuseteils von unten, in eine Öffnung eines Ansetzelements des Gehäuseteils hinein;
- Fig. 6B: eine perspektivische Ansicht des Befestigungsteils der Halterungseinrichtung;
- Fig. 7: eine Ansicht der Halterungseinrichtung, bei an einen runden Stromleiter ohne Verwendung eines Befestigungsteils angesetztem Gehäuseteil;
- Fig. 8: eine schematische Ansicht der Anbringung mehrerer Rogowskispulen an mehreren Stromschienen; und
- Fig. 9: eine schematische Ansicht einer Rogowskispule.

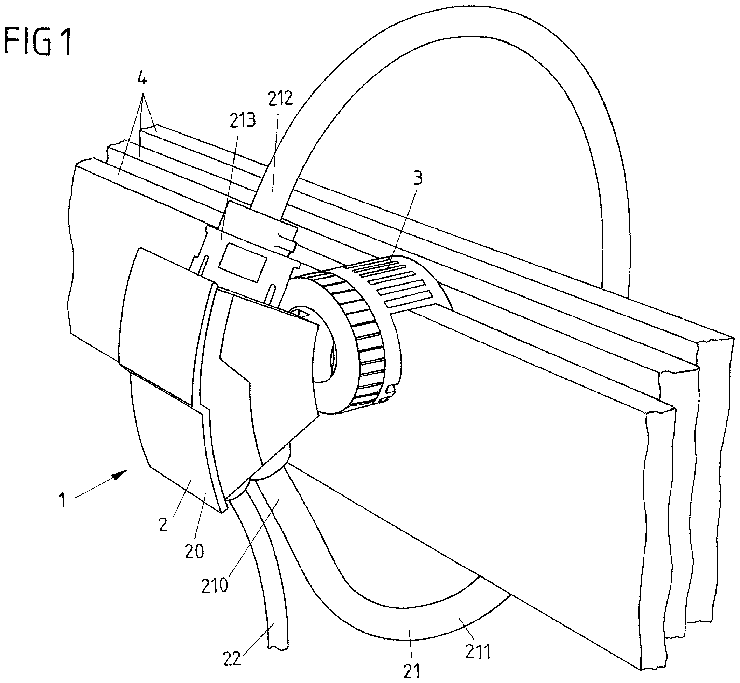

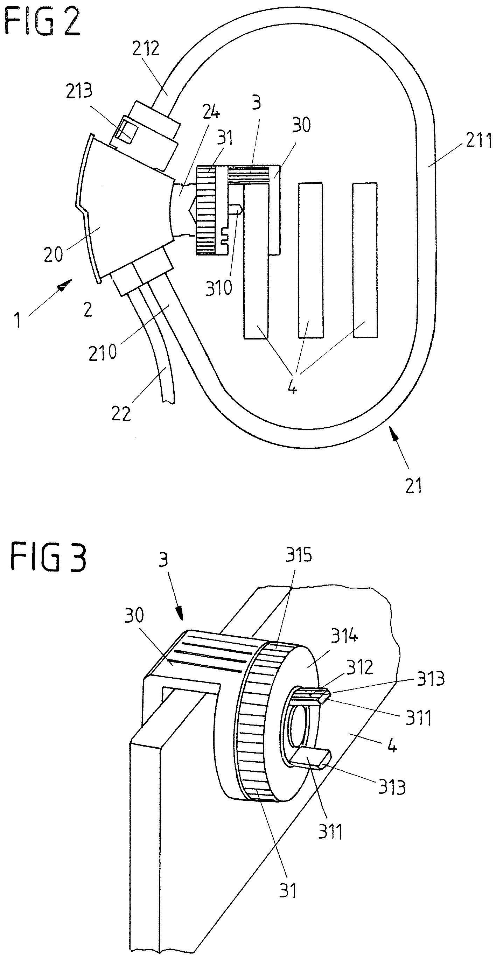

Fig. 1 und 2 zeigen eine Halterungseinrichtung 1, mit der eine Rogowskispule 21 an einer oder mehreren Stromleitungseinrichtungen 4, beispielsweise Stromschienen eines Schaltschranks oder dergleichen, fixiert werden kann.

Die Halterungseinrichtung 1 umfasst ein Gehäuseteil 2, das in lösbarer Weise mit einem Befestigungsteil 3 verbunden ist und die Rogowskispule 21 trägt. Das Befestigungsteil 3 kann an eine Stromleitungseinrichtung 4 angesetzt werden, so dass über das Befestigungsteil 3 die Haltungseinrichtung 1 an der Stromleitungseinrichtung 4 festgelegt werden kann.

Die Rogowskispule 21 ist mit einem ersten Ende 210 mechanisch fest mit einem Gehäusekörper 20 des Gehäuseteils 2 verbunden und an diesem Ende 210 elektrisch über Anschlüsse 230, 231 mit einer Auswerteelektronik 23 verbunden. An ihrem anderen, zweiten Ende 212 ist die Rogowskispule 21 über eine mechanische Verschlusseinrichtung 213, beispielsweise in Form eines Bajonette-Verschlusses, lösbar mit dem Gehäusekörper 20 des Gehäuseteils 2 verbunden, so dass die Rogowskispule 21 bei gelöstem, zweitem Ende 212 um die Stromleitungseinrichtung 4 herumgelegt und sodann mechanisch über die Verschlussvorrichtung 213 an dem Gehäuseteil 2 fixiert werden kann.

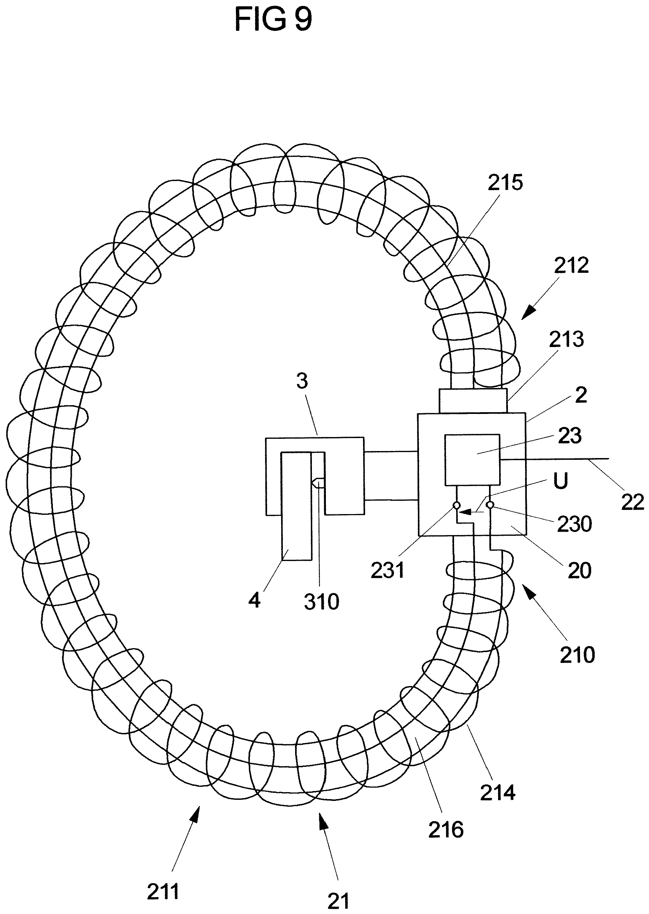

Die Rogowskispule 21, schematisch dargestellt in Fig. 9, wird gebildet durch einen Leiterdraht, der um einen festen, nicht ferromagnetischen Körper 216 herumgewickelt ist. Ein erster Leitungsabschnitt 214 des Leiterdrahts ist hierbei in gleichförmiger Weise um den Körper 216 herumgewickelt und am ersten Ende 210 der Rogowskispule 21 mit einem ersten Anschluss 230 der Auswerteelektronik 23 verbunden, während ein zweiter Leitungsabschnitt 215 von dem zweiten Ende 212 der Rogowskispule 21 entlang des Körpers 216 in magnetisch neutraler Weise hin zum ersten Ende 210 zurückgeführt und mit einem zweiten Anschluss 231 der Auswerteelektronik 23 verbunden ist. Im Betrieb induziert ein in der Stromleitungseinrichtung 4 geführter Wechselstrom an der Rogowskispule 21 eine Spannung U, die zwischen den Anschlüssen 230, 231 abgegriffen und in der Auswerteelektronik 23 ausgewertet werden kann, um über eine Anschlussleitung 22 ein Sensorsignal auszugeben, das den in der Stromleitungseinrichtung 4 geführten Wechselstrom anzeigt. In einer weiteren Ausführungsform wird die zwischen den Anschlüssen 230, 231 abgegriffene Spannung über die Anschlussleitung 22 an eine außerhalb des Gehäuses 2 angeordnete Auswerteelektronik (nicht dargestellt) weitergeleitet.

Zwischen den Enden 210, 212 der Rogowskispule 21 erstreckt sich die eigentliche Spule 211, in der im Betrieb aufgrund eines Wechselstroms in der Stromleitungseinrichtung 4 eine Spannung induziert wird, die an den Anschlüssen 230, 231 anliegt und entsprechend abgegriffen werden kann.

Der Körper 216 der Rogowskispule 21 ist vorteilhafterweise derart biegsam, dass die Rogowskispule 21 in flexibler Weise um eine oder mehrere Stromleitungseinrichtungen 4, beispielsweise parallel zueinander erstreckte Stromschienen, herumverlegt werden kann, wie dies in Fig. 1 und 2 dargestellt ist.

Die Rogowskispule 21 kann eine Ummantelung, beispielsweise eine Kunststoffummantelung, aufweisen, so dass der die Leitungsabschnitte 214, 215 bildende Leiterdraht von außen nicht sichtbar ist.

Die Halterungseinrichtung 1 umfasst, wie gesagt, ein Gehäuseteil 2, an dem die eigentliche Rogowskispule 21 angeordnet ist, und ein Befestigungsteil 3, das zum Festlegen an einer Stromleitungseinrichtung 4 dient.

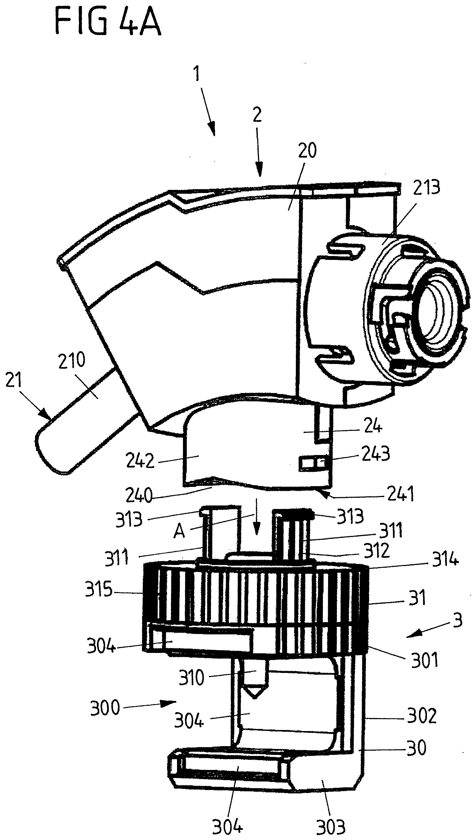

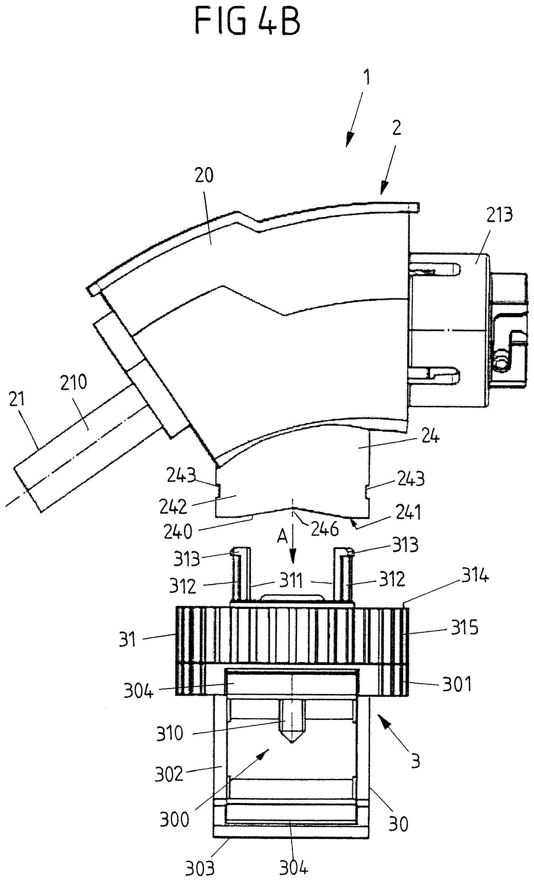

Wie aus Fig. 3 und Fig. 4A-4C ersichtlich, weist das Befestigungsteil 3 ein Halteelement 30 und ein zu dem Halteelement 30 verdrehbares Verbindungselement 31 auf. Das Halteelement 30 bildet eine im Querschnitt U-förmige Aufnahmeöffnung 300 aus, gebildet durch eine an einen Körper 301 anschließende Basis 302 und einen daran angeordneten Schenkel 303. In die U-förmige Aufnahmeöffnung 300 ist ein Winkelelement 304 aus Metall eingesetzt, das bei an eine Stromleitungseinrichtung 4 angesetztem Befestigungsteil 3 eine Anlagefläche für die Stromleitungseinrichtung 4 bereitstellt.

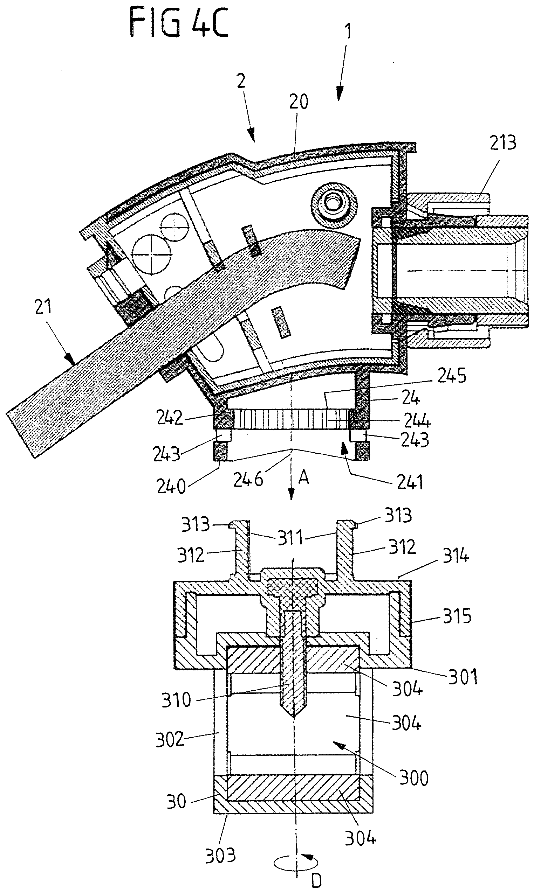

Das Verbindungselement 31 ist um eine Ansetzrichtung A (siehe z.B. Fig. 4A) relativ zu dem Körper 301 des Halteelements 30 verdrehbar. Wie aus der Längsschnittansicht gemäß Fig. 4C ersichtlich, weist das Verbindungselement 31 ein Klemmelement 310 auf, das fest mit einem Körper 314 des Verbindungselements 31 verbunden ist und nach Art einer Schraube ausgestaltet ist und mit einer in dem Winkelelement 304 vorgesehenen Durchgriffsöffnung in Gewindeeingriff steht derart, dass durch Verdrehen des Verbindungselements 31 relativ zu dem Halteelement 30 das Klemmelement 310 relativ zu dem Winkelelement 304 verstellt werden kann. Das Klemmelement 310 ragt in die Aufnahmeöffnung 300 hinein und ermöglicht ein Verklemmen des Winkelelements 304 mit einer darin angeordneten Stromleitungseinrichtung 4.

Der Körper 314 trägt an einer um die Ansetzrichtung A erstreckten Umfangswandung 315 eine Riffelung, so dass ein Nutzer das Verbindungselement 31 durch Angreifen an der Umfangswandung 315 relativ zu dem Halteelement 30 verdrehen kann.

Das Gehäuseteil 2 kann in die Ansetzrichtung A an das Befestigungsteil 3 angesetzt werden. Das Gehäuseteil 2 weist hierzu ein in die Ansetzrichtung A an den Gehäusekörper 20 anschließendes Ansetzelement 24 mit einer zylindrischen Grundform auf, das an seinem dem Befestigungsteil 3 zugewandten Ende eine Öffnung 241 ausbildet, mit der das Ansetzelement 24 auf Rastelemente 311 an dem Verbindungselement 31 des Befestigungsteils 3 aufgesetzt werden kann.

Die Rastelemente 311 stehen entgegen der Ansetzrichtung A von dem Verbindungselement 31 des Befestigungsteils 3 vor. Das Befestigungsteil 3 weist zwei Rastelemente 311 auf, die sich diametral gegenüberstehen und an ihren vom Verbindungselement 31 abliegenden Enden jeweils ein Sperrstück 313 in Form einer nach außen vorspringenden Rastnase tragen. Bei Ansetzen des Gehäuseteils 2 in die Ansetzrichtung A an das Befestigungsteil 3 werden die Rastelemente 311 in die Öffnung 241 des Ansetzelements 24 eingeführt, so dass die Sperrstücke 313 der Rastelemente 311 rastend mit einem Formschlosselement in Form eines Rands 245 einer Ratschverzahnung 244 innerhalb der Öffnung 241 in Eingriff gelangen und hierdurch das Gehäuseteil 2 axial entlang der Ansetzrichtung A relativ zu dem Befestigungsteil 3 festlegen.

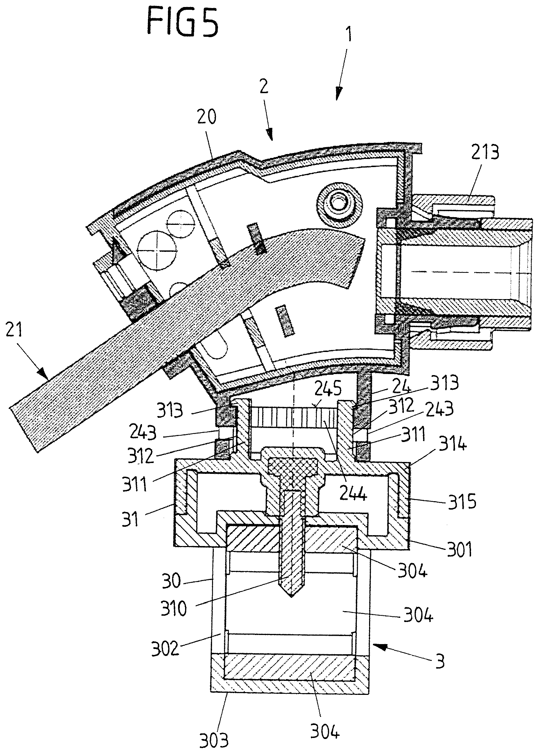

In verbundenem Zustand stehen die Rastelementen 311, wie in Fig. 5 dargestellt, mit dem vom Befestigungsteil 3 abliegenden Rand 245 der Ratschverzahnung 244 innerhalb der Öffnung 241 des Ansetzelements 24 in Eingriff, so dass das Gehäuseteil 2 formschlüssig mit dem Befestigungsteil 3 verbunden ist.

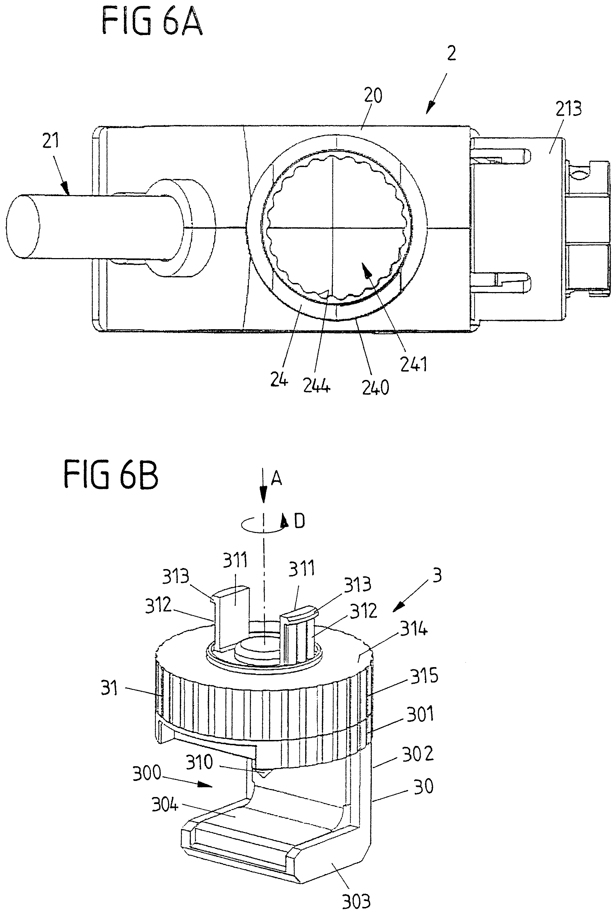

Die Rastelemente 311 weisen an ihren Außenseiten jeweils Ratschelemente 312 in Form eines Abschnitts einer Ratschverzahnung aus, wie dies aus Fig. 6B ersichtlich ist. Die Ratschverzahnung 244 innerhalb der Öffnung 241 des Ansetzelements 24 ist demgegenüber durch in Umfangsrichtung um die Ansetzrichtung A periodisch aneinander anschließende Zähne gebildet, deren Spitzen abgerundet sind und die der Ratschverzahnung 312 der Rastelemente 311 angepasst sind. Ist das Gehäuseteil 2 mit dem Befestigungsteil 3 verbunden, wie dies in Fig. 5 dargestellt ist, so stehen die Ratschverzahnungen 312 der Rastelemente 311 in Eingriff mit der Ratschverzahnung 244 innerhalb der Öffnung 241 des Ansetzelements 24, wobei der Eingriff derart ist, dass das Gehäuseteil 2 entlang einer Drehrichtung D um die Ansetzrichtung A relativ zu dem Befestigungsteil 3 verdreht werden kann. Bei Verdrehen gleiten die Ratschverzahnungen 312 an den Rastelementen 311 des Befestigungsteils 3 in ratschender Weise über die Ratschverzahnung 244 des Ansetzelements 24 hinweg, so dass das Gehäuseteil 2 zu dem Befestigungsteil 3 in eine gewünschte Lage gebracht werden kann und, nach Erreichen der gewünschten Lage, in seiner Stellung verbleibt.

Durch den Eingriff der Ratschverzahnungen 312 an den Rastelementen 311 mit der Ratschverzahnung 244 innerhalb der Öffnung 241 des Ansetzelements 24 wird eine Vielzahl von möglichen, diskreten Winkelstellungen des Gehäuseteils 2 relativ zu dem Befestigungsteil 3 vorgegeben. Beispielsweise kann durch den Eingriff der Ratschverzahnungen 244, 312 ineinander das Gehäuseteil 2 in Schritten von 15° relativ zu dem Befestigungsteil 3 verdreht werden.

Zum Anbringen wird zunächst das Befestigungsteil 3 an eine Stromleitungseinrichtung 4 angesetzt und durch Verdrehen des Verbindungselements 31 relativ zu dem Halteelement 30 das Klemmelement 310 klemmend mit der Stromleitungseinrichtung 4 in Verbindung gebracht. Sodann wird das Gehäuseteil 2 an das Befestigungsteil 3 angesetzt und hierüber eine formschlüssige Verbindung zwischen dem Gehäuseteil 2 und dem Befestigungsteil 3 hergestellt. Durch Verdrehen des Gehäuseteils 2 entlang der Drehrichtung D relativ zu dem Befestigungsteil 3 kann schließlich die Lage der Rogowskispule 21 relativ zu der Stromleitungseinrichtung 4 in gewünschter Weise eingestellt werden.

Durch Lösen des Gehäuseteils 2 von dem Befestigungsteil 3 kann die Rogowskispule 21 auch wieder von einer Stromleitungseinrichtung 4 abgenommen werden. Hierzu wird die Rogowskispule 21 mit ihrem zweiten Ende 212 durch Lösen der Verschlussvorrichtung 213 von dem Gehäusekörper 20 gelöst und sodann das Gehäuseteil 2 von dem Befestigungsteil 3 entgegen der Ansetzrichtung A abgezogen.

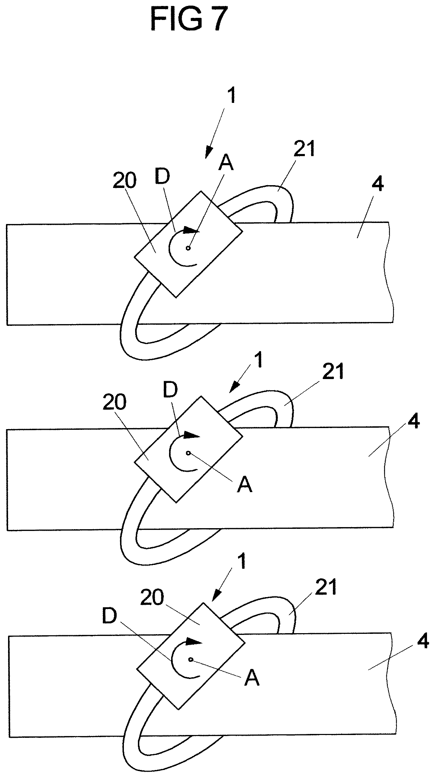

Aufgrund der Drehbarkeit des Gehäuseteils 2 relativ zu dem Befestigungsteil 3 kann die Lage der Rogowskispule 21 zu einer Stromleitungseinrichtung 4 in gewünschter Weise angepasst werden. So kann beispielsweise, wie dies schematisch in Fig. 7 dargestellt ist, vorgesehen sein, an mehreren parallel zueinander erstreckten Stromleitungseinrichtungen 4 in Form von Stromschienen über mehrere Rogowskispulen 21 den Strom zu messen. Um hierbei eine Anordnung der Rogowskispulen 21 an einer Stromleitungseinrichtung 4 zu ermöglichen, ohne dass die Rogowskispulen 21 eine andere Stromleitungseinrichtung 4 berühren, können die Rogowskispulen 21 jeweils durch Verdrehen des Gehäuseteils 2 entlang der Drehrichtung D relativ zu dem Befestigungsteil 3 der jeweils zugeordneten Halterungseinrichtung 1 in eine beispielsweise schräge Lage gebracht werden, so dass die Rogowskispulen 21 zwischen benachbarten Stromleitungseinrichtungen 4 hindurch verlegt werden können. Durch die Haltungseinrichtungen 1 werden die Rogowskispulen 21 in ihrer gewünschten, eingestellten Lage gehalten und können im späteren Messbetrieb nicht ohne weiteres verrutschen oder in sonstiger Weise ihre Lage verändern.

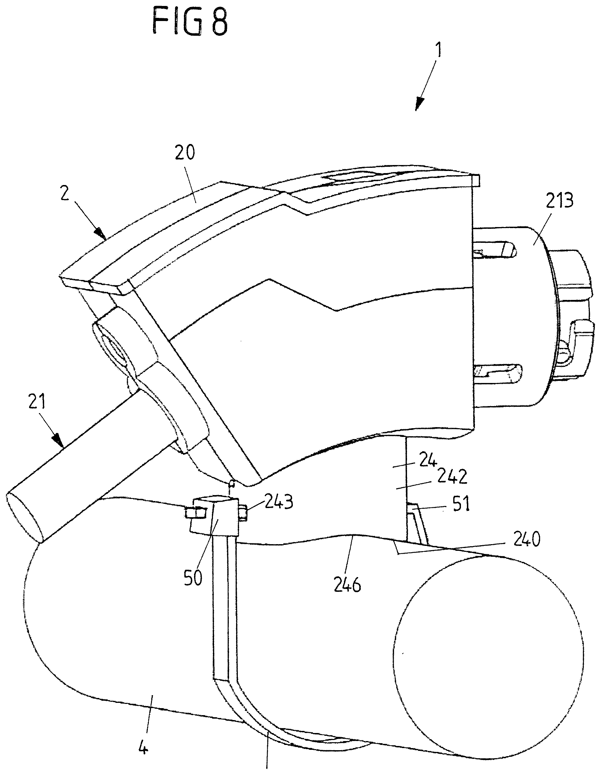

Die Halterungseinrichtung 1 kann grundsätzlich auch ohne das Befestigungsteil 3 verwendet werden. So kann, wie in Fig. 8 dargestellt, das Gehäuseteil 2 mit der daran angeordneten Rogowskispule 21 über das Ansetzelement 24 an eine Stromleitungseinrichtung 4 beispielsweise in Form eines Stromleiters mit rundem Leitungsquerschnitt angesetzt werden. Um eine definierte Anlage bereitzustellen, weist das Ansetzelement 24 an seinem vom Gehäusekörper 20 abliegenden Randabschnitt 240 eine konkave Formgebung auf, die zum Ansetzen an Stromleitungseinrichtungen 4 in Form von Stromleitern mit rundem Leitungsquerschnitt angepasst sein kann. Beispielsweise kann der untere Randabschnitt 240 eine Einkerbung 246 ausbilden, die an eine Stromleitungseinrichtung 4 angesetzt werden kann, wie dies in Fig. 8 dargestellt ist.

Das Ansetzelement 24 ist zylindrisch geformt und weist an seiner äußeren Mantelfläche 242 zwei diametral gegenüberliegende Befestigungsöffnungen 243 auf, durch die hindurch eine Befestigungseinrichtung 5 in Form eines Kabelbinders geführt werden kann. Über die Befestigungseinrichtung 5 kann das Gehäuseteil 2 an einer Stromleitungseinrichtung 4 festgelegt werden, indem ein Abschnitt 51 der als Kabelbinder ausgebildeten Befestigungseinrichtung 5 durch die Befestigungsöffnungen 243 hindurchgeführt und mit einem Steckverschluss 50 des Kabelbinders in Eingriff gebracht wird.

Der Gehäusekörper 20 des Gehäuseteils 2 kann einteilig oder auch mehrteilig ausgebildet sein. Beispielsweise kann, in einer konkreten Ausgestaltung, der Gehäusekörper 2 aus zwei Gehäusehälften zusammengesetzt sein, so dass der Gehäusekörper 20 für einen Zugriff auf die darin angeordnete Auswerteelektronik 23 auch geöffnet werden kann.

Die Auswerteelektronik 23 kann insbesondere eine Vorverstärkung und Vorverarbeitung der über die Rogowskispule 21 erhaltenen Signale bereitstellen. Von der Auswerteelektronik 23 können Sensorsignale über die Anschlussleitung 22 beispielsweise hin zu einer übergeordneten Auswerte- und Steuereinrichtung übertragen werden.

Der der Erfindung zugrunde liegende Gedanke ist nicht auf die vorrangehend geschilderten Ausführungsbeispiele beschränkt, sondern lässt sich grundsätzlich auch in gänzlich anders gearteter Weise bei anderen Ausführungsformen verwirklichen.

Insbesondere kann eine Rogowskispule 21 der hier beschriebenen Art nicht nur an Stromschienen, sondern an beliebigen Stromleitungseinrichtungen, an denen ein Wechselstrom gemessen werden soll, eingesetzt werden. Die Rogowskispule kann hierbei in ihrer Länge so angepasst sein, dass die Rogowskispule um einen oder mehrere Stromleiter herumgelegt werden kann.

### Bezugszeichenliste

- 1: Halteeinrichtung
- 2: Gehäuseteil
- 20: Gehäusekörper
- 21: Rogowskispule
- 210: Ende
- 211: Spule
- 212: Ende
- 213: Verschlusseinrichtung
- 214,215: Leitungsabschnitt
- 216: Körper
- 22: Anschlussleitung
- 23: Auswerteelektronik
- 230,231: Anschluss
- 24: Ansetzelement
- 240: Randabschnitt
- 241: Öffnung
- 242: Mantelfläche
- 243: Befestigungsöffnung
- 244: Ratschverzahnung
- 245: Rand
- 3: Befestigungsteil
- 30: Halteelement
- 300: Aufnahmeöffnung
- 301: Körper
- 302: Basis
- 303: Schenkel
- 304: Winkelelement
- 31: Verbindungselement
- 310: Klemmelement
- 311: Rastelemente
- 312: Ratschverzahnung
- 313: Sperrstück
- 314: Körper
- 315: Umfangswandung
- 4: Stromleitungseinrichtung
- 5: Befestigungseinrichtung (Kabelbinder)
- 50: Steckverschluss
- 51: Abschnitt
- A: Ansetzrichtung
- D: Drehrichtung
- U: Spannung

## Patentansprüche

1. Halterungseinrichtung, mit
- einer Rogowskispule, die einen zu einer Spule gewickelten Leitungsabschnitt aufweist,
- einem Gehäuseteil, mit dem die Rogowskispule verbunden ist, und
- einem Befestigungsteil (3), das an eine zum Leiten eines Stroms ausgebildete Stromleitungseinrichtung (4) ansetzbar und lösbar mit dem Gehäuseteil (2) verbindbar ist,
**dadurch gekennzeichnet, dass**
das Gehäuseteil (2) in verbundenem Zustand entlang einer Drehrichtung (D) zu dem Befestigungsteil (3) verdrehbar ist,
das Befestigungsteil (3) eine Ratschverzahnung (312, 244) und das Gehäuseteil ein Ratschelement (244, 312) aufweist oder vice versa, wobei
die Ratschverzahnung (312, 244) in verbundenem Zustand mit dem zugeordneten Ratschelement (312, 244) derart in Eingriff steht, dass das Gehäuseteil (2) und das Befestigungsteil (3) in verbundenem Zustand ratschend zueinander verstellbar sind, indem das Ratschelement (312, 244) über die Ratschverzahnung (244, 312) bewegbar ist.

2. Halterungseinrichtung nach Anspruch 1, **dadurch gekennzeichnet, dass** das Gehäuseteil (2) zum Verbinden mit dem Befestigungsteil (3) in eine Ansetzrichtung (A) an das Befestigungsteil (3) ansetzbar ist.

3. Halterungseinrichtung nach Anspruch 1 oder 2, **dadurch gekennzeichnet, dass** das Gehäuseteil (2) in verbundenem Zustand formschlüssig mit dem Befestigungsteil (3) verbunden ist.

4. Halterungseinrichtung nach einem der vorangehenden Ansprüche, **dadurch gekennzeichnet, dass** das Befestigungselement (3) mindestens ein Rastelement (311) aufweist und das Gehäuseteil (2) mindestens eine Formschlusselement (245) aufweist oder vice versa, wobei das Rastelement (311) durch Ansetzen des Gehäuseteils (2) an das Befestigungsteil (3) rastend mit dem Formschlusselement (245) in Eingriff bringbar und in verbundenem Zustand formschlüssig mit dem Formschlusselement (245) in Eingriff steht.

5. Halterungseinrichtung nach einem der vorangehenden Ansprüche, **dadurch gekennzeichnet, dass** das Gehäuseteil (2) ein Ansetzelement (24) aufweist, mit dem das Gehäuseteil (2) an das Befestigungsteil (3) ansetzbar ist.

6. Halterungseinrichtung nach Anspruch 5, **dadurch gekennzeichnet, dass** das Ansetzelement (24) eine Öffnung (241) aufweist, in die das das Befestigungsteil (3) mit mindestens einem Rastelement (311) einsetzbar ist und in der ein Formschlusselement (245) zum Eingriff mit dem mindestens einen Rastelement (311) des Befestigungsteils (3) angeordnet ist.

7. Halterungseinrichtung nach Anspruch 5 oder 6, **dadurch gekennzeichnet, dass** das Ansetzelement (24) an einem Randabschnitt (246) derart konkav geformt ist, dass das Ansetzelement (24) mit seinem Randabschnitt (246) an eine im Leitungsquerschnitt runde Stromleitereinrichtung (4) ansetzbar ist.

8. Halterungseinrichtung nach Anspruch 7, **dadurch gekennzeichnet, dass** das Ansetzelement (24) mindestens eine Befestigungsöffnung (243) als Durchgriff für eine Befestigungseinrichtung (5) zum Befestigen des Gehäuseteils (2) an einer im Leitungsquerschnitt runden Stromleitereinrichtung (4) aufweist.

9. Halterungseinrichtung nach einem der vorangehenden Ansprüche, **dadurch gekennzeichnet, dass** das Befestigungsteil (3) ein Halteelement (30), über das das Befestigungsteil (3) an die Stromleitungseinrichtung (4) ansetzbar ist, und ein zu dem Halteelement (30) verstellbares Verbindungselement (31), das mit dem Gehäuseteil (2) verbindbar ist, aufweist.

10. Halterungseinrichtung nach Anspruch 9, **dadurch gekennzeichnet, dass** das Verbindungselement (30) ein Klemmelement (310) zum Befestigen der Stromleitungseinrichtung (4) an dem Halteelement (30) aufweist, wobei das Klemmelement (310) durch Verstellen des Verbindungselements (310) relativ zu dem Halteelement (30) verstellbar ist.

11. Halterungseinrichtung nach Anspruch 9 oder 10, **dadurch gekennzeichnet, dass** das Halteelement (30) eine Aufnahmeöffnung (300) zur Aufnahme der Stromleitungseinrichtung (4) aufweist.

12. Halterungseinrichtung nach Anspruch 10 oder 11, **dadurch gekennzeichnet, dass** das Halteelement (30) einen Körper (301), eine an dem Körper (301) angeordnete Basis (302) und einen an die Basis (302) anschließenden Schenkel (303) aufweist, wobei der Körper (301), die Basis (302) und der Schenkel (303) zwischen sich eine U-förmige Aufnahmeöffnung ausbilden.

13. Halterungseinrichtung nach Anspruch 11 oder 12, **dadurch gekennzeichnet, dass** das Haltelement (30) ein aus Metall gefertigtes, in der Aufnahmeöffnung (300) angeordnetes Winkelelement (304) zur Anlage mit der Stromleitungseinrichtung (4) aufweist.

14. Halterungseinrichtung nach einem der vorangehenden Ansprüche, **dadurch gekennzeichnet, dass** die Rogowskispule mit einem ersten Ende (210) fest mit dem Gehäuseteil (20) verbunden und mit einem anderen, zweiten Ende (211) lösbar mit dem Gehäuseteil (20) verbindbar ist.

15. Halterungseinrichtung nach einem der vorangehenden Ansprüche, **dadurch gekennzeichnet, dass** das Gehäuseteil (2) eine Auswerteelektronik (23) zum Auswerten von über die Rogowskispule (21) erhaltenen Signalen (U) aufweist.

## Claims

1. Holder device, comprising
- a Rogowski coil which has a line section which is wound to form a coil,
- a housing part to which the Rogowski coil is connected, and
- a fastening part (3) which can be attached to a current conducting device (4), which is designed to conduct a current, and can be releasably connected to the housing part (2),
**characterized in that**
the housing part (2), in the connected state, can be rotated along a rotation direction (D) to the fastening part (3),
the fastening part (3) has a ratchet tooth system (312, 244) and the housing part has a ratchet element (244, 312), or vice versa, wherein
the ratchet tooth system (312, 244), in the connected state, engages with the associated ratchet element (312, 244) in such a way that the housing part (2) and the fastening part (3), in the connected state, can be adjusted in relation to one another with a ratchet action by the ratchet element (312, 244) being moved over the ratchet tooth system (244, 312).

2. Holder device according to Claim 1, **characterized in that** the housing part (2), for connection to the fastening part (3), can be attached to the fastening part (3) in an attachment direction (A).

3. Holder device according to Claim 1 or 2, **characterized in that** the housing part (2), in the connected state, is connected to the fastening part (3) in an interlocking manner.

4. Holder device according to one of the preceding claims, **characterized in that** the fastening element (3) has at least one latching element (311) and the housing part (2) has at least one interlocking element (245) or vice versa, wherein the latching element (311) can engage with the interlocking element (245) in a latching manner by attachment of the housing part (2) to the fastening part (3) and, in the connected state, engages with the interlocking element (245) in an interlocking manner.

5. Holder device according to one of the preceding claims, **characterized in that** the housing part (2) has an attachment element (24) by way of which the housing part (2) can be attached to the fastening part (3).

6. Holder device according to Claim 5, **characterized in that** the attachment element (24) has an opening (241) into which the fastening part (3) can be inserted by way of at least one latching element (311) and in which an interlocking element (245) is arranged for engaging with the at least one latching element (311) of the fastening part (3).

7. Holder device according to Claim 5 or 6, **characterized in that** the attachment element (24) is concavely shaped at an edge section (246) in such a way that the attachment element (24), by way of its edge section (246), can be attached to a current conducting device (4) of round line cross section.

8. Holder device according to Claim 7, **characterized in that** the attachment element (24) has at least one fastening opening (243) as a passage for a fastening device (5) for fastening the housing part (2) to a current conductor device (4) of round line cross section.

9. Holder device according to one of the preceding claims, **characterized in that** the fastening part (3) has a holding element (30) by means of which the fastening part (3) can be attached to the current conducting device (4), and a connecting element (31) which can be adjusted in relation to the holding element (30) and can be connected to the housing part (2) .

10. Holder device according to Claim 9, **characterized in that** the connecting element (30) has a clamping element (310) for fastening the current conducting device (4) to the holding element (30), wherein the clamping element (310) can be adjusted relative to the holding element (30) by adjusting the connecting element (310).

11. Holder device according to Claim 9 or 10, **characterized in that** the holding element (30) has a receiving opening (300) for receiving the current conducting device (4).

12. Holder device according to Claim 10 or 11, **characterized in that** the holding element (30) has a body (301), a base (302) which is arranged on the body (301), and a limb (303) which adjoins the base (302), wherein the body (301), the base (302) and the limb (303) form a U-shaped receiving opening between them.

13. Holder device according to Claim 11 or 12, **characterized in that** the holding element (30) has an angled element (304), which is manufactured from metal and is arranged in the receiving opening (300), for making contact with the current conducting device (4).

14. Holder device according to one of the preceding claims, **characterized in that** the Rogowski coil is fixedly connected to the housing part (20) by way of a first end (210) and can be detachably connected to the housing part (20) by way of another, second end (211).

15. Holder device according to one of the preceding claims, **characterized in that** the housing part (2) has an evaluation electronics system (23) for evaluating signals (U) obtained via the Rogowski coil (21).

## Revendications

1. Système de maintien, comprenant
- un enroulement de Rogowski, lequel comporte un tronçon de ligne enroulé en un enroulement,
- un élément formant boîtier, avec lequel l'enroulement de Rogowski est relié et
- un élément de fixation (3), lequel est susceptible d'être monté sur un système de ligne électrique (4), conçu pour conduire un courant et de manière amovible sur l'élément formant boîtier (2),
**caractérisé en ce que**
en position reliée, l'élément formant boîtier (2) est rotatif le long d'une direction de rotation (D) par rapport à l'élément de fixation (3),
l'élément de fixation (3) comporte une denture d'encliquetage (312, 244) et l'élément formant boîtier comporte un élément d'encliquetage (244, 312) ou vice versa,
dans la position reliée, la denture d'encliquetage (312, 244) est en engagement avec l'élément d'encliquetage (312, 244), de telle sorte qu'en position reliée, l'élément formant boîtier (2) et l'élément de fixation (3) soient ajustables l'un par rapport à l'autre, **en ce que** l'élément d'encliquetage (312, 244) est déplaçable par l'intermédiaire de la denture d'encliquetage (244, 312).

2. Système de maintien selon la revendication 1, **caractérisé en ce que** pour la liaison avec l'élément de fixation (3), l'élément formant boîtier (2) peut s'appliquer dans une direction d'application (A) sur l'élément de fixation (3).

3. Système de maintien selon la revendication 1 ou 2, **caractérisé en ce que** dans la position reliée, l'élément formant boîtier (2) est relié par complémentarité de forme avec l'élément de fixation (3) .

4. Système de maintien selon l'une quelconque des revendications précédentes, **caractérisé en ce que** l'élément de fixation (3) comporte au moins un élément d'enclenchement (311) et **en ce que** l'élément formant boîtier (2) comporte au moins un élément de complémentarité de forme (245) ou vice versa, par application de l'élément formant boîtier (2) sur l'élément de fixation (3), l'élément d'enclenchement (311) pouvant être amené en engagement par enclenchement avec l'élément de complémentarité de forme (245) et en position reliée, étant en engagement par complémentarité de forme avec l'élément de complémentarité de forme (245).

5. Système de maintien selon l'une quelconque des revendications précédentes, **caractérisé en ce que** l'élément formant boîtier (2) comporte un élément d'application (24) par lequel l'élément formant boîtier (2) est applicable sur l'élément de fixation (3).

6. Système de maintien selon la revendication 5, **caractérisé en ce que** l'élément d'application (24) comporte un orifice (241) dans lequel l'élément de fixation (3) est insérable par au moins un élément d'enclenchement (311) et dans lequel est placé un élément de complémentarité de forme (245), destiné à s'engager dans l'au moins un élément d'enclenchement (311) de l'élément de fixation (3).

7. Système de maintien selon la revendication 5 ou 6, **caractérisé en ce que** sur un segment marginal (246), l'élément d'application (24) est façonné de forme concave, de telle sorte que par son segment marginal (246), l'élément d'application (24) puisse s'appliquer sur un système de ligne électrique (4) ayant une section transversale de ligne ronde.

8. Système de maintien selon la revendication 7, **caractérisé en ce que** l'élément d'application (24) comporte au moins un orifice de fixation (243) faisant office de passage pour un système de fixation (5) destiné à fixer l'élément formant boîtier (2) sur un système conducteur de courant (4) ayant une section transversale de ligne ronde.

9. Système de maintien selon l'une quelconque des revendications précédentes, **caractérisé en ce que** l'élément de fixation (3) comporte un élément de retenue (30) par l'intermédiaire duquel l'élément de fixation (3) peut s'appliquer sur le système de ligne électrique (4) et un élément de liaison (31) ajustable par rapport à l'élément de retenue (30), qui est susceptible d'être relié avec l'élément formant boîtier (2) .

10. Système de maintien selon la revendication 9, **caractérisé en ce que** l'élément de liaison (30) comporte un élément de serrage (310), destiné à fixer le système de ligne électrique (4) sur l'élément de retenue (30), l'élément de serrage (310) étant ajustable par ajustage de l'élément de liaison (310) par rapport à l'élément de retenue (30).

11. Système de maintien selon la revendication 9 ou 10, **caractérisé en ce que** l'élément de retenue (30) comporte un orifice de logement (300), destiné à loger le système de ligne électrique (4).

12. Système de maintien selon la revendication 10 ou 11, **caractérisé en ce que** l'élément de retenue (30) comporte un corps (301), une base (302) placée sur le corps (301) et une branche (303) se raccordant sur la base (302), le corps (301), la base (302) et la branche (303) formant entre eux un orifice de logement en forme de U.

13. Système de maintien selon la revendication 11 ou 12, **caractérisé en ce que** l'élément de retenue (30) comporte un élément angulaire (304) fabriqué en métal, placé dans l'orifice de logement (300), destiné à être appliqué sur le système de ligne électrique (4).

14. Système de maintien selon l'une quelconque des revendications précédentes, **caractérisé en ce que** par une première extrémité (210), l'enroulement de Rogowski est solidement relié avec l'élément formant boîtier (20) et est susceptible d'être relié de manière dissociable par une deuxième, autre extrémité (211) avec l'élément formant boîtier (20).

15. Système de maintien selon l'une quelconque des revendications précédentes, **caractérisé en ce que** l'élément formant boîtier (2) comporte un système électronique d'évaluation (23), destiné à évaluer des signaux (U) obtenus par l'intermédiaire de l'enroulement de Rogowski (21).
